**Europäisches Patentamt**

**European Patent Office**

**Office européen des brevets**

(19)

(11) Numéro de publication: **0 082 070**
**A1**

(12)

# DEMANDE DE BREVET EUROPEEN

(21) Numéro de dépôt: **82402247.9**

(51) Int. Cl.³: **H 01 R 13/02**

(22) Date de dépôt: **08.12.82**

(30) Priorité: **15.12.81 FR 8123403**

(71) Demandeur: **Schnitzler, Raymond, 4 bis, rue des Augustins, F-22300 Lannion (FR)**
Demandeur: **Ramy, Jean-Pierre, 3 Résidence Duroux, F-22300 Lannion (FR)**

(43) Date de publication de la demande: **22.06.83**
**Bulletin 83/25**

(72) Inventeur: **Schnitzler, Raymond, 4 bis, rue des Augustins, F-22300 Lannion (FR)**
Inventeur: **Ramy, Jean-Pierre, 3 Résidence Duroux, F-22300 Lannion (FR)**

(74) Mandataire: **Mongrédien, André et al, c/o BREVATOME 25, rue de Ponthieu, F-75008 Paris (FR)**

(84) Etats contractants désignés: **BE CH DE GB IT LI**

(54) **Procédé de protection d'une pièce conductrice et pièce conductrice obtenue par ce procédé.**

(57) Procédé de revêtement d'une pièce conductrice et pièce obtenue par ce procédé.
Selon l'invention le revêtement est en nitrure de titane.
Application à la protection des contacts électriques.

EP 0 082 070 A1

La présente invention a pour objet un procédé de protection d'un conducteur métallique et un conducteur métallique obtenu par ce procédé. Elle trouve une application notamment dans la protection des contacts électriques utilisés dans les relais, les connecteurs, etc...

Actuellement, les revêtements protecteurs de conducteurs utilisent des couches de métaux précieux tels que l'or, l'argent-cuivre, l'argent-palladium, le platine, l'argent, l'iridium, etc... Ces revêtements présentent deux inconvénients : ils sont chers et présentent une faible dureté.

La présente invention a justement pour but d'éviter ces inconvénients. Ce but est atteint selon l'invention par l'utilisation, comme revêtement protecteur, de nitrure de titane. Ce matériau est beaucoup moins onéreux que les métaux utilisés précédemment et il possède une dureté exceptionnelle. De plus, il est réfractaire, sa stabilité chimique est très grande, et il présente une conductivité électrique satisfaisante. Enfin, ces propriétés sont obtenues pour de très faibles épaisseurs.

De façon plus précise, la présente invention a donc pour objet un procédé de protection d'une pièce conductrice par revêtement, procédé qui est caractérisé en ce qu'il consiste à déposer sur cette pièce une couche de nitrure de titane.

La présente invention a également pour objet une pièce conductrice obtenue par ce procédé, qui est caractérisée en ce qu'elle est revêtue d'une couche en nitrure de titane.

Le dépôt protecteur en nitrure de titane présente les propriétés suivantes :

1) une excellente adhérence (supérieure à 180 kg/cm$^2$)

B 7447 C/RS

2) une excellente inertie chimique (il satisfait notamment à l'essai d'atmosphère industrielle en $H_2S$ pur)

3) une excellente résistance à l'abrasion,

4) une résistivité de l'ordre de 500 $\mu\Omega$.cm, qui peut être ajustée par le taux de nitruration.

La technologie de dépôt du nitrure de titane peut faire appel à la pulvérisation cathodique, avec, par exemple, l'argon comme gaz traceur. Il est bien entendu que ceci n'est pas limitatif : le dépôt peut aussi s'obtenir par pulvérisation réactive de titane, ou par évaporation thermique (par bombardement électronique d'une cible en nitrure de titane) ou encore par évaporation thermique réactive de titane. Le dépôt chimique en phase vapeur (CVD) convient aussi, en particulier pour une méthode industrielle.

A titre d'exemple, un processus technologique conforme à l'invention pour la protection de lames et de plots de connecteurs en cuivre-béryllium et en bronze phosphoreux peut être le suivant :

a) préparation des plots et des lames :

- décapage par immersion dans une solution sulfochromique,

- polissage électrochimique précédé d'une immersion dans une solution d'acide nitrique à 50% pendant 30 secondes, d'un rinçage à l'eau désionisée froide pendant 10 minutes et d'un séchage par jet d'argon ; le bain de polissage est constitué d'un mélange de 700 cm$^3$ d'acide orthophosphorique ($H_3PO_4$) et de 300 cm$^3$ d'eau désionisée, la cathode est en cuivre et le courant est de 40 mA/cm$^2$ ; le polissage dure 30 minutes et toutes les 2 minutes les pièces à polir, qui constituent l'anode, sont retirées du bain, rincées à l'eau désionisée puis séchées par jet d'argon.

- dégraissage par immersion dans des bains ultrasoniques d'acétone puis d'éthanol.

- rinçage à l'eau désionisée

- séchage par jet d'argon.

  b) dépôt du matériau :

la matériau protecteur est déposé par pulvérisation cathodique en radiofréquence dans une enceinte à vide, à l'aide d'une cible en nitrure de titane ; le vide initial dans l'enceinte est de l'ordre de $10^{-6}$ torr. La pression d'argon nécessaire à la formation du plasma est de $8.10^{-3}$ torr. La puissance appliquée est de l'ordre de 300 watts.

0082070

## REVENDICATIONS

1. Procédé de protection d'une pièce conductrice par revêtement, caractérisé en ce qu'il consiste à déposer sur cette pièce une couche de nitrure de titane.

2. Procédé selon la revendication 1, caractérisé en ce que la pièce est un contact électrique.

3. Pièce conductrice obtenue par le procédé de la revendication 1, caractérisée en ce qu'elle est revêtue d'une couche de nitrure de titane.

4. Pièce conductrice selon la revendication 2, caractérisée en ce qu'elle est en cuivre ou à base de cuivre.

B 7447 C/RS

**Office européen des brevets**

## RAPPORT DE RECHERCHE EUROPEENNE

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | IEEE TRANSACTIONS ON PARTS, MATERIALS AND PACKAGING, vol. PMP-5, no. 2, juin 1969, pages 99-103, New York, USA<br>J.C. KOSCO: "The effects of electrical conductivity and oxidation resistance on temperature rise of circuit-breaker contact materials" * Page 99, colonne 2, lignes 6-18; page 102, colonne 2, lignes 11-19 * | 1-3 | H 01 R 13/02 |
| | --- | | |
| A | MATERIALPRÜFUNG, Band 18, Nr. 6, juin 1976, pages 207-212, Düsseldorf, DE.<br>J. EHLERT et al.: "Aufgedampfte Geber zur Messwerterfassung in elastohydrodynamischen Kontakten" * Page 207, colonne 2, lignes 27-45; page 211, colonne 1, lignes 10-32 * | 1-3 | |
| | --- | | |
| A | FR-A-2 338 585 (OLIN CORP.) * Revendications 1,4 * | 1-4 | |
| | --- | | |
| A | FR-A-1 398 387 (IMPERIAL CHEMICAL) * Page 3, colonne 2, lignes 13-23 * | 1-4 | |
| | ----- | | |

**DOMAINES TECHNIQUES RECHERCHES (Int. Cl. ³)**

H 01 R 13/00
H 01 H 1/00
H 01 B 1/00

Le présent rapport de recherche a été établi pour toutes les revendications

| Lieu de la recherche | Date d'achèvement de la recherche | Examinateur |
|---|---|---|
| LA HAYE | 18-03-1983 | WAERN G.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
_____
& : membre de la même famille, document correspondant

OEB Form 1503. 03.82